# EUROPEAN PATENT APPLICATION

(11) **EP 4 697 886 A1**
(43) Date of publication of application: **18.02.2026**
(21) Application number: 25169996.3
(22) Date of filing: 11.04.2025
(51) Int. Cl.: H10B 12/00, H10D 30/01, H10D 30/62

(54) **SEMICONDUCTOR DEVICE**

(30) Priority: 14.08.2024 KR 20240109381
(71) Applicant: Samsung Electronics Co., Ltd., Suwon-si, Gyeonggi-do 16677 (KR)
(72) Inventor: JANG, Hyeri, Suwon-si, Gyeonggi-do 16677 (KR); JANG, Sungho, Suwon-si, Gyeonggi-do 16677 (KR); OH, Jeonghoon, Suwon-si, Gyeonggi-do 16677 (KR); LEE, Chul, Suwon-si, Gyeonggi-do 16677 (KR); HUR, Kijae, Suwon-si, Gyeonggi-do 16677 (KR)
(74) Representative: Kuhnen & Wacker Patent- und Rechtsanwaltsbüro PartG mbB

(57) **Abstract**

A semiconductor device includes: a memory cell array region including memory cells (MC) connected to respective word lines (WL) and bit lines (BL); and a peripheral circuit region including a first semiconductor element (170a) and a second semiconductor element (170b). Each of the first and second semiconductor elements (170a, 170b) includes: a fin structure (105a; 105b) extending in a first direction (X) on a substrate (103a; 103b); a gate structure (110a; 110b) extending on the fin structure (105a; 105b) in a second direction (Y), perpendicular to the first direction (X), and including a gate dielectric layer (111a, 113a; 111b, 113b) and a gate metal layer (112a; 112b); and a source region (120a; 120b) and a drain region (130a; 130b) in the substrate (103a; 103b) at opposing ends of the fin structure (105a; 105b). A thickness of the gate dielectric layer (111a) in the first semiconductor element (170a) is greater than a thickness of the gate dielectric layer (111b) in the second semiconductor element (170b), and the source and drain regions (120a, 130a) in the first semiconductor element (170a) are doped with first conductivity type impurities and have different structures.

## Description

### BACKGROUND

The present disclosure relates generally to a semiconductor device.

Semiconductor devices are a decisive part of the electronics industry, and both a storage device for storing data and a processor for processing data may be implemented with semiconductor devices. A FINFET element may be used as a semiconductor device to improve the degree of integration thereof, and research on the FINFET element capable of operating under high voltage conditions is also actively underway. In the FINFET element operating under high voltage, it is necessary to improve characteristics such as Hot Carrier Injection (HCI) and Gate Induced Drain Leakage (GIDL), which affect the reliability of the device.

### SUMMARY

An aspect of the present disclosure is to provide a semiconductor device having improved reliability, particularly while operating under high voltage conditions.

A semiconductor device according to an example embodiment of the present disclosure includes: a memory cell array region including a plurality of memory cells connected to a plurality of word lines and a plurality of bit lines; and a peripheral circuit region including a first semiconductor element of a first element region and a second semiconductor element of a second element region, and each of the first semiconductor element and the second semiconductor element includes: a substrate; a fin structure extending in a first direction on the substrate; a gate structure extending in a second direction on the fin structure, perpendicular to the first direction, and including a gate dielectric layer and a gate metal layer; and a source region and a drain region in the substrate of both ends of the fin structure and spaced apart from each other. A thickness of the gate dielectric layer included in the first semiconductor element is greater than a thickness of the gate dielectric layer included in the second semiconductor element, and the source region and the drain region included in the first semiconductor element are doped with first conductivity type impurities and have different structures.

A semiconductor device according to an example embodiment of the present disclosure includes: a substrate; a fin structure extending on the substrate in a first direction parallel to an upper surface of the substrate; a gate structure extending on the fin structure in a second direction parallel to the upper surface of the substrate and perpendicular to the first direction; and a source region and a drain region formed in the substrate of both ends of the fin structure and spaced apart from each other, and sizes of the source region and the drain region are substantially identical to each other, and the source region and the drain region are in different positions in a third direction, perpendicular to the first direction and the second direction, respectively, based on the gate structure.

A semiconductor device according to an example embodiment includes: a substrate; a fin structure extending in a first direction on the substrate; a gate structure extending in a second direction, perpendicular to the first direction, on the fin structure; and a source region and a drain region formed in the substrate of both ends of the fin structure and spaced apart from each other, and a size of the drain region is greater than a size of the source region, and a shortest distance in a third direction, perpendicular to an upper surface of the substrate, between lower surfaces of the gate structure and the drain region is less than a shortest distance between lower surfaces of the gate structure and the source region.

According to an embodiment of the present disclosure, a source region and a drain region included in a semiconductor device may have different structures, thereby reducing an electric field around a region in which a gate structure and a drain region overlap each other. Since the source region and the drain region of the semiconductor device have different structures, a semiconductor device having improved HCI and GIDL characteristics may be provided, thereby improving the reliability of the semiconductor device.

Advantages and effects of the present disclosure are not limited to the foregoing content and may be more easily understood in the process of describing a specific example embodiment of the present disclosure.

### BRIEF DESCRIPTION OF DRAWINGS

The above and other aspects, features, and advantages of the present disclosure will be more clearly understood from the following detailed description, taken in conjunction with the accompanying drawings, wherein like reference numerals (when used) indicate corresponding elements throughout the several views, and in which:
FIGS. 1 and 2 are schematic views simply illustrating a semiconductor device according to an example embodiment of the present disclosure;
FIG. 3 is a schematic view simply illustrating a sub-word line driver according to an example embodiment of the present disclosure;
FIG. 4 is a schematic plan view simply illustrating an element region according to an example embodiment of the present disclosure;
FIG. 5A is a schematic cross-sectional view illustrating a cross-section taken in a direction along line I-I' of FIG. 4;
FIG. 5B is a schematic cross-sectional view illustrating a cross-section taken in a direction along line II-II' of FIG. 4;
FIGS. 6 to 11 are schematic views simply illustrating cross-sections of a gate structure of a semiconductor device according to example embodiments of the present disclosure;
FIG. 12 is a schematic plan view simply illustrating an element region according to an example embodiment of the present disclosure;
FIGS. 13 to 16 are schematic cross-sectional views illustrating cross-sections taken in a direction along line III-III' of FIG. 12; and
FIGS. 17A to 20B are schematic views illustrating intermediate processes in a method of manufacturing a semiconductor device according to an example embodiment of the present disclosure.

### DETAILED DESCRIPTION

Hereinafter, example embodiments of the present disclosure will be described with reference to the accompanying drawings.

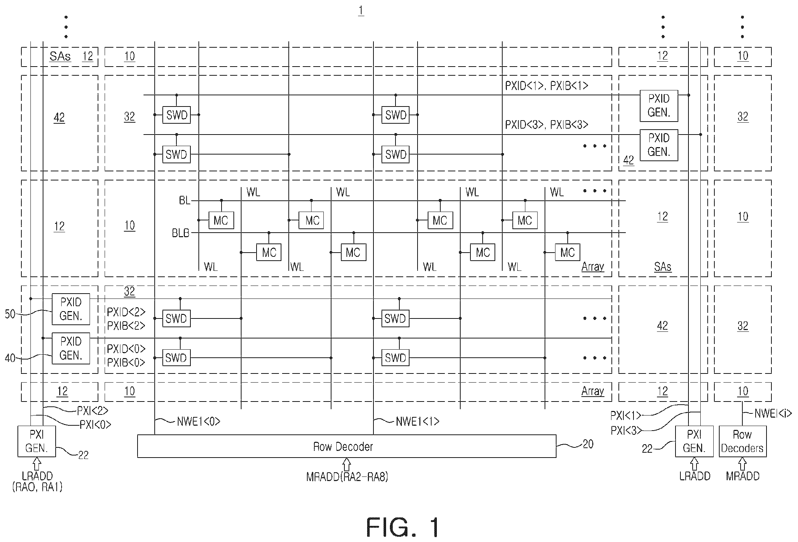

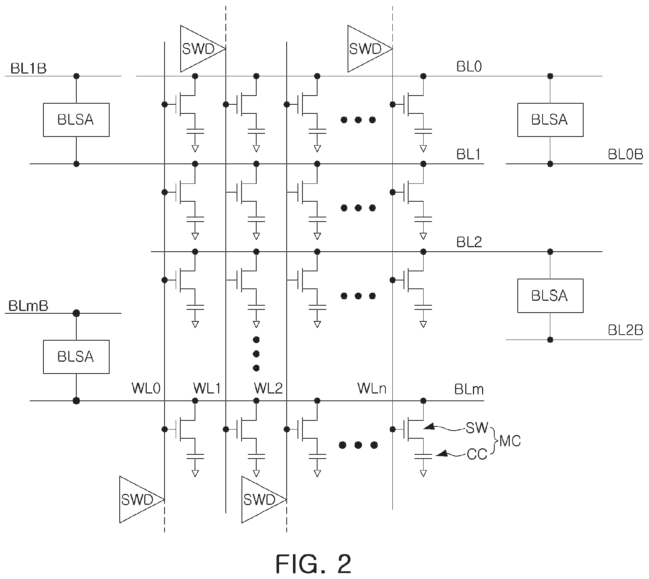

FIGS. 1 and 2 are views simply illustrating a semiconductor device according to an example embodiment of the present disclosure.

First, FIG. 1 may be a block diagram simply illustrating a structure of a semiconductor device according to an example embodiment of the present disclosure. The semiconductor device according to an example embodiment of the present disclosure may be a dynamic random access memory (DRAM). In the example embodiment illustrated in FIG. 1, a semiconductor device 1 may include a row decoder 20, pre-decoders 22, connection circuits 42, word line driving circuits 32, cell arrays 10, and sense amplifier circuits 12.

The row decoder 20 may decode an upper row address MRADD and may select a word line corresponding to the upper row address MRADD from word lines WL in response to the upper row addresses RA2 to RA8 (MRADD) received from the outside.

In other words, the row decoder 20 may determine a selected word line from the word lines WL in response to the upper row address MRADD. For example, the row decoder 20 may output a word line enable signal NWEI (e.g., NWEI<0> to NWEI<i>, where i is a natural number) for the purpose of enabling the selected word line to the corresponding word line drive circuit 32. The row decoder 20 includes logic gates, and the logic gates may be formed of semiconductor elements. For example, the logic gates may be formed of a p-channel metal-oxide-semiconductor (PMOS) transistor and/or an n-channel metal-oxide-semiconductor (NMOS) transistor.

The pre-decoders 22 may output pre-decoding signals PXI (e.g., PXI<0> to PXI<3>) in response to lower row addresses LRADD (e.g., RA0 to RA1). For example, the pre-decoders 22 may decode the lower row address LRADD among the row addresses input from the outside, and may generate pre-decoding signals PXI corresponding to the selected word line. The pre-decoding signals PXI may be input to driving signal generators 40 and 50 included in the connection circuits 42.

The driving signal generators 40 and 50 may generate driving signals PXID (e.g., PXID<0> to PXID<3>) and PXIB (e.g., PXIB<0> to PXIB<3>) for driving the word lines WL in response to the pre-decoding signals PXI. For example, the driving signal generators 40 and 50 may include a pull-up circuit that may increase the driving signals PXID and PXIB by a predetermined voltage level. The driving signals PXID and PXIB may be output to sub-word line drivers SWD included in the word line drive circuits 32.

The semiconductor device 1 may include a memory cell region and a peripheral circuit region around (e.g., surrounding) the memory cell region. The memory cell region may be a region in which memory cells for data storage are disposed. The peripheral circuit region may be a region in which a word line driver, a sense amplifiers, a row decoder, a column decoder, and control circuits are disposed.

The sub-word line drivers SWD may activate the selected word line in response to the word line enable signal NWEI and the driving signals PXID and PXIB, and may perform a precharge operation. For example, the driving signal generators 40 and 50 may increase a level of a first driving signal PXID input to the sub-word line driver SWD connected to the selected word line from a first voltage to a second voltage, the second voltage being higher than the first voltage, and may set a level of a second driving signal PXIB to the first voltage. The term "connected" (or "connecting," or like terms, such as "contact" or "contacting"), as may be used herein, is intended to refer to a physical and/or electrical connection between two or more elements, and may include other intervening elements. As used herein, the term "and/or" includes any and all combinations of one or more of the associated listed items. The sub-word line driver SWD that receives the first driving signal PXID having the second voltage and the second driving signal PXIB having the first voltage may input the first driving signal PXID to the selected word line.

Meanwhile, an unselected word line driver SWD connected to one or more unselected word lines not selected by the word line enable signal NWEI may input a predetermined voltage to the unselected word lines. In an example embodiment, the voltage input to the unselected word lines may be lower than the second voltage. For example, the voltage input to the unselected word lines may be a negative constant voltage lower than 0 volts (V).

In the cell arrays 10, memory cells MC may be connected to the word lines WL and bit lines BL. Each of the memory cells MC may include a storage capacitor and a switch element. This will be described in more detail below with reference to FIG. 2.

Referring to FIG. 2, which illustrates a portion of the semiconductor device 1 shown in FIG. 1, each of the memory cells MC may include a storage capacitor CC and a switch element SW connected to the storage capacitor CC. A control terminal of the switch element SW may be connected to a corresponding word line of the plurality of word lines WL0 to WLn (where n is a natural number), and a first input terminal of the switch element SW may be connected to a corresponding one of the plurality of bit lines BL0 to BLm and BLOB to BLmB (where m is a natural number). A second input terminal of the switch element SW may be connected to the storage capacitor CC. The word lines WL0 to WLn may be connected to the sub-word line drivers SWD, and the bit lines BL0 to BLm and BLOB to BLmB may be connected to sense amplifiers BLSA.

Semiconductor devices are a decisive part of the electronics industry, and both a storage device for storing data and a processor for processing data may be implemented with semiconductor devices. A FINFET element is used as a semiconductor device to improve the degree of integration, and research on the FINFET element capable of operating under high voltage conditions is also actively underway. However, in the FINFET element operating under high voltage, there may be a concern that the reliability of the element may be deteriorated.

A semiconductor device according to an example embodiment of the present disclosure may include a plurality of semiconductor elements. In an example embodiment, the plurality of semiconductor elements may be FINFET elements. Some of the plurality of semiconductor elements may operate by receiving a relatively high voltage. The relatively high voltage may refer to a case in which a voltage applied between a source region and a drain region is a voltage of 3 V or higher. For example, the sense amplifier may include semiconductor elements that operate by receiving a relatively low voltage, and the sub-word line driver may include semiconductor elements operating by receiving a relatively high voltage.

A semiconductor device according to an example embodiment of the present disclosure may include at least one semiconductor element in which a source region and a drain region have different structures. The different structures may denote that the source region and drain region do not have substantially the same structure. In an example embodiment, the semiconductor elements receiving a relatively high voltage may have different structures in the source region and the drain region.

The source region and the drain region of the semiconductor element may be formed to have different structures, thereby reducing an electric field around a region in which a gate structure and a drain region overlap each other in a vertical direction. As used herein, "an element A overlapping an element B in a direction X" (or similar language) means that there is at least one line that extends in the direction X and intersects both the elements A and B. Specifically, the electric field may be reduced in a lateral (i.e., horizontal) direction. Since the source region and the drain region have different structures, it may be possible to minimize a peak of the electric field formed in a path in which charges move from the source region to the drain region. Accordingly, it may be possible to provide a semiconductor element having improved HCI and GIDL characteristics, and accordingly, it may be possible to improve the reliability of the semiconductor element.

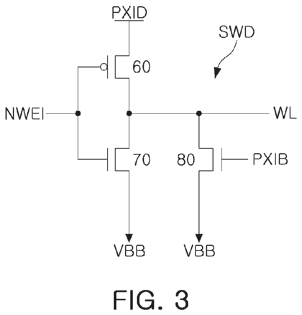

FIG. 3 is a view simply illustrating a sub-word line driver according to an example embodiment of the present disclosure.

Referring to FIG. 3, the sub-word line driver SWD may include a PMOS transistor 60, a first NMOS transistor 70, and a second NMOS transistor 80. The PMOS transistor 60 may have a first driving signal PXID connected to a source thereof, a word line enable signal NWEI connected to a gate thereof, and a word line WL connected to a drain thereof. The first NMOS transistor 70 may have a back bias voltage VBB connected to a source thereof, a word line enable signal NWEI connected to a gate thereof, and a word line WL connected to a drain thereof. The second NMOS transistor 80 may have a second driving signal PXIB connected to a gate thereof, a back bias voltage VBB connected to a source thereof, and a word line WL connected to a drain thereof.

The word line enable signal NWEI may be a signal generated on a ground voltage level in response to the word line enable signal NWEI activated on a boosting voltage level. In response to the sub-word line enable signal NWEI of the ground voltage level and the first driving signal PXID of the boosting voltage level, the sub-word line WL may have a boosting voltage level. During the precharge operation, in response to the sub-word line enable signal NWEI of the boosting voltage level and the second driving signal PXIB, the sub-word line WL may have a back bias voltage VBB level.

In an example embodiment of the present disclosure, at least one of the PMOS transistor 60, the first NMOS transistor 70, and the second NMOS transistor 80, which are semiconductor elements included in the sub-word line driver SWD, may be a FINFET transistor. In this specification, the semiconductor element is exemplified as including a FINFET, but the present disclosure is not limited thereto. The structure and arrangement relationship of the source region and drain region described below may also be applied to a planar element or a Gate All Around (GAA) element, or the like.

In an example embodiment of the present disclosure, the source region and the drain region of the FINFET element may be formed to have different structures. The source region and the drain region of the FINFET element may be formed to have different structures, thus reducing the peak of the electric field around the region in which the gate structure and the drain region overlap each other. As the source region and the drain region of the semiconductor element have different structures, it may be possible to provide a semiconductor element having improved HCI and GIDL characteristics, thereby improving the reliability of the semiconductor element.

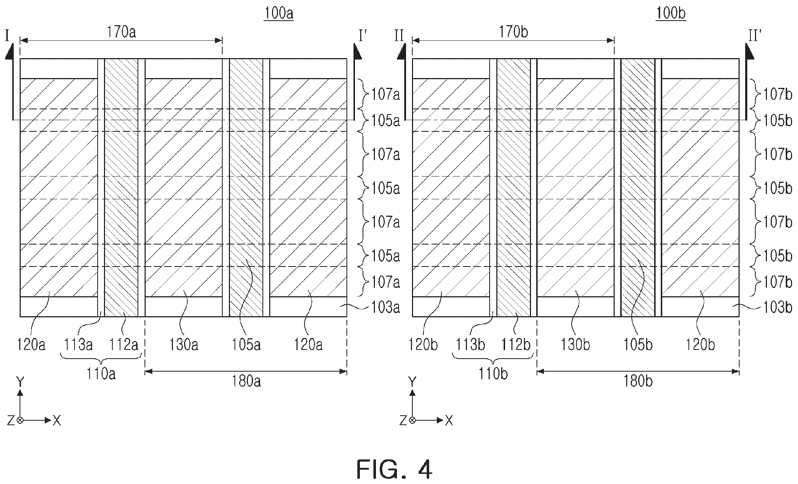

FIG. 4 is a schematic plan view simply illustrating an element region according to an example embodiment of the present disclosure.

Referring to FIG. 4, a semiconductor device according to an example embodiment of the present disclosure may include a first element region 100a and a second element region 100b in a peripheral circuit region. The first element region 100a and the second element region 100b may include an NMOS region and/or a PMOS region, respectively. In an example embodiment, the first element region 100a may include semiconductor elements driven by receiving a relatively high voltage, and the second element region 100b may include semiconductor elements driven by receiving a relatively low voltage.

The first element region 100a may include a first semiconductor element 170a and a second semiconductor element 180a. In an example embodiment, the first semiconductor element 170a and the second semiconductor element 180a may be included in the sub-word line driver. Referring to FIG. 3 as an example, the first semiconductor element 170a may be a first NMOS transistor 70 of the sub-word line driver SWD, and the second semiconductor element 180a may be a second NMOS transistor 80 of a sub-word line driver SWD. Each of the first semiconductor element 170a and the second semiconductor element 180a may include a source region 120a and may share a drain region 130a.

The second element region 100b may include a third semiconductor element 170b (which is an example of the second semiconductor element in the claims) and a fourth semiconductor element 180b. In an example embodiment, the third semiconductor element 170b and the fourth semiconductor element 180b may be included in the sense amplifier. Referring to FIG. 2 as an example, sense amplifiers BLSA operating by receiving a relatively low voltage may be disposed in the second element region 100b.

The first element region 100a and the second element region 100b may include substrates 103a and 103b having a plurality of fin structures 105a and 105b, active regions provided on the substrate 103a and 103b to provide source regions 120a and 120b and drain regions 130a and 130b, and gate structures 110a and 110b disposed between the active regions and extending to intersect the plurality of fin structures 105a and 105b. The active region may be formed of silicon (Si), and may be doped with, for example, N-type impurities such as phosphorus (P), nitrogen (N), arsenic (As), or antimony (Sb).

The substrate 103a and 103b may be a base on which a semiconductor element is manufactured, and may include a well region. The substrate 103a and 103b may have a recessed region partially removed from an upper surface thereof. The substrate 103a and 103b may be provided, for example, as a bulk wafer, an epitaxial layer, a silicon on insulator (SOI) layer, or a semiconductor on insulator (SeOI) layer. The substrate 103a and 103b may include a semiconductor material, such as a group IV semiconductor, a group III-V compound semiconductor, or a group II-VI compound semiconductor. For example, the group IV semiconductor may include silicon, germanium, or silicon germanium. The substrate 103a and 103b may include first conductivity type impurities, such as P-type impurities, but the present disclosure is not limited thereto.

The first element region 100a and the second element region 100b may include a plurality of fin structures 105a and 105b extending in a first direction (X-axis direction) on the substrate 103a and 103b, and gate structures 110a and 110b extending in a second direction (Y-axis direction) to intersect the plurality of fin structures 105a and 105b. The plurality of fin structures 105a and 105b may be formed to protrude from upper surfaces of the substrate 103a and 103b and may have a fin shape.

The active region may include a base active region and a plurality of fin structures 105a and 105b. The plurality of fin structures 105a and 105b may include impurities. The plurality of fin structures 105a and 105b may be separated by respective element isolating films 107a and 107b in the substrate, and may extend in the first direction (X-axis direction). The plurality of fin structures 105a and 105b may be spaced apart from the element isolating films 107a and 107b in a second direction (Y-axis direction). Adjacent fin structures 105a may be spaced apart in the second direction (Y-axis direction) by the element isolating films 107a, and adjacent fin structures 105b may be spaced apart in the second direction (Y-axis direction) by the element isolating films 107b. The element isolating films 107a and 107b may include an insulating material such as silicon oxide, silicon nitride, or silicon oxide.

In order to form the source regions 120a and 120b and the drain regions 130a and 130b, remaining portions of the plurality of fin structures 105a and 105b on both sides of the gate structures 110a and 110b may be removed. A selective epitaxial growth (SEG) process may be applied from the remaining portions of the plurality of fin structures 105a and 105b, thus forming the source regions 120a and 120b and the drain regions 130a and 130b.

The gate structures 110a and 110b may extend in the second direction (Y-axis direction), and may intersect the plurality of fin structures 105a and 105b extending in the first direction (X-axis direction), intersecting the second direction. Each of the gate structures 110a and 110b may include gate metal layers 112a and 112b, respectively, and gate spacers 113a and 113b, respectively. The gate spacers 113a and 113b may be formed on each side surface of the gate metal layers 112a and 112b.

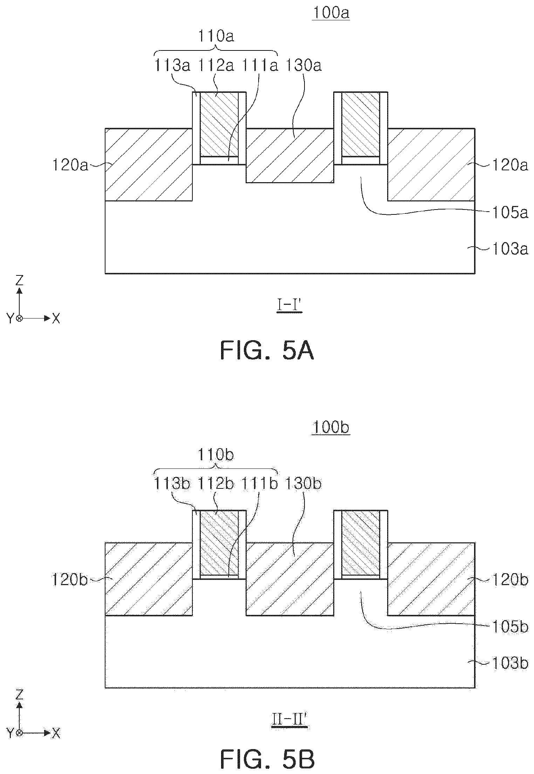

FIG. 5A is a schematic cross-sectional view illustrating a cross-section taken along line I-I' of FIG. 4.

Referring to FIG. 5A, the first element region 100a may include a substrate 103a, a plurality of fin structures 105a extending on the substrate 103a in the first direction (X-axis direction), and a gate structure 110a extending on the plurality of fin structures 105a in the second direction (Y-axis direction). In an example embodiment, the first element region 100a may be included in the word line driver. The gate structures 110a on the plurality of fin structures 105a may extend in the second direction (Y-axis direction). The gate structures 110a may be spaced apart from each other in the first direction (X-axis direction) with active regions interposed therebetween. For example, a transistor may be formed in a region in which the gate structures 110a and the plurality of fin structures 105a intersect each other.

The gate structure 110a may include a gate insulating layer 111a, a gate metal layer 112a, and gate spacers 113a. The gate insulating layer 111a and the gate spacers 113a are examples of a gate dielectric layer. The gate insulating layer 111a may be disposed between the gate metal layer 112a and the plurality of fin structures 105a. The gate spacers 113a, formed of an insulating material, may be disposed on opposing side surfaces of the gate metal layer 112a, and active regions, extending in the first direction (X-axis direction), may be provided on the outside of the gate spacers 113a.

The active regions may provide the source region 120a and the drain region 130a of the semiconductor element, and may have an elevated source/drain form in which an upper surface thereof is higher than a lower surface of the gate structure 110a in a third direction (Z-axis direction), relative to a surface (e.g., lower surface) of the substrate 103a as a reference layer. In an example embodiment illustrated in FIGS. 5A to 11, the active regions are illustrated as having a rectangular shape, but the active regions may have various shapes, and the active regions may have for example, one of a polygonal shape and a circular shape. The active regions may have a structure in which the active regions are connected to each other or merged on three fin structures 105a. The number of fin structures 105a connected to each other in one active region may be changed.

When the semiconductor element is an NMOS transistor, the fin structures 105a and the active regions may include silicon (Si). The active regions may include the source region 120a and the drain region 130a. The source region 120a and the drain region 130a may be regions that are epitaxially grown from the fin structures 105a. The source region 120a and the drain region 130a may be doped with first conductivity type impurities, and may have different doping concentrations according to example embodiments. For example, the first conductivity type impurities may be N-type impurities, and a doping concentration of the drain region 130a may be lower than a doping concentration of the source region 120a.

As described above, the first element region 100a according to an example embodiment of the present disclosure may include a FINFET element to improve the degree of integration. However, since there is a concern that the HCI and GIDL characteristics affecting the reliability of the element may be deteriorated in the FINFET element operating by receiving a relatively high voltage, the source region 120a and the drain region 130a of the FINFET element may have different structures.

The different structures may denote that the source region 120a and the drain region 130a do not have substantially the same characteristics (e.g., dimensions, shape, doping concentration, etc.). For example, referring to FIG. 5A, in a third direction (Z-axis direction), a lower surface of the drain region 130a may be disposed above a lower surface of the source region 120a, relative to the surface of the substrate 103a. In other words, the shortest distance between a lower surface of the gate structure 110a and the lower surface of the drain region 130a may be less than the shortest distance between the lower surface of the gate structure 110a and the lower surface of the source region 120a.

The source region 120a and the drain region 130a of the semiconductor element may be formed to have different structures, thereby reducing the peak of the electric field around a region in which the gate structure 110a and the drain region 130a overlap each other in the third direction (Z-axis direction). Accordingly, the semiconductor element having improved HCI and GIDL characteristics may be provided, thereby improving the reliability of the semiconductor element.

FIG. 5B is a schematic cross-sectional view illustrating a cross-section taken along line II-II' of FIG. 4.

Referring to FIG. 5B, the second element region 100b may include a substrate 103b, a plurality of fin structures 105b extending on the substrate 103b in the first direction (X-axis direction), and a gate structure 110b extending in the second direction (Y-axis direction). In an example embodiment, the second element region 100b may be included in the sense amplifier.

The gate structure 110b may include a gate insulating layer 111b, a gate metal layer 112b, and gate spacers 113b. The gate insulating layer 111b and the gate spacers 113b are examples of a gate dielectric layer. The gate insulating layer 111b may be disposed between the gate metal layer 112b and the plurality of fin structures 105b. The gate spacers 113b, formed of an insulating material, may be disposed on opposing side surfaces of the gate metal layer 112b, and active regions, extending in the first direction (X-axis direction), may be provided on the outside of the gate spacers 113b. The active regions may provide the source region 120b and the drain region 130b of the semiconductor element, and may have an elevated source/drain form in which an upper surface thereof is higher than a lower surface of the gate structure 110b in the third direction (Z-axis direction), relative to the surface of the substrate 103b as a reference layer.

Referring to FIGS. 4, 5A and 5B together, the first element region 100a may include a semiconductor element driven by receiving a relatively high voltage, and the second element region 100b may include a semiconductor element driven by receiving a relatively low voltage. For example, the first element region 100a may be included in the sub-word line driver, and the second element region 100b may be included in the sense amplifier.

A thickness in the third direction (Z-axis direction) of the gate insulating layer 111a included in the first element region 100a may be greater than a thickness in the third direction of a gate insulating layer 111b included in the second element region 100b. Since a semiconductor element operating by receiving a relatively high voltage may require a relatively high breakdown voltage, the semiconductor element may include a relatively thick gate insulating layer 111a. Since a semiconductor element operating by receiving a relatively low voltage may not require a relatively high breakdown voltage, the semiconductor element may include a relatively thin gate insulating layer 111b. Accordingly, the thickness in the third direction (Z-axis direction) of the gate insulating layer 111a included in the first element region 100a to which a relatively high voltage is applied may be greater than the thickness in the third direction of the gate insulating layer 111b included in the second element region 100b to which a relatively low voltage is applied.

Referring to FIGS. 5A and 5B together, the source region 120a and the drain region 130a included in the first element region 100a may have different characteristics (e.g., dimensions, shape, doping concentration, etc.), and the source region 120b and the drain region 130b included in the second element region 100b may have substantially the same characteristics. In an example embodiment, the different characteristics of the source and drain regions 120a, 130a in the first element region 100a may be manifest in that the lower surface of the drain region 130a is higher than the lower surface of the source region 120a in the third direction (Z-axis direction).

In the first element region 100a operating by receiving a relatively high voltage, there may be a concern that the HCI and GIDL characteristics affecting the reliability of the element may be deteriorated, and thus, the first element region 100a may be intentionally formed so that the source region 120a and the drain region 130a have different structures. Meanwhile, in the second element region 100b operating by receiving a relatively low voltage, the source region 120b and the drain region 130b may not have different structures.

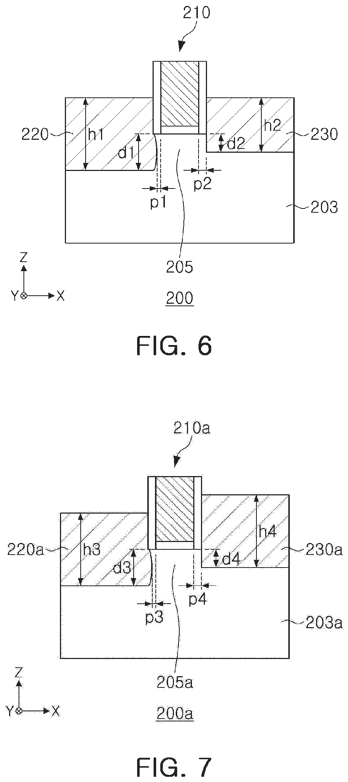

FIGS. 6 to 11 are schematic views simply illustrating cross-sections of at least a portion of a semiconductor device according to example embodiments of the present disclosure.

In an example embodiment of the present disclosure, the semiconductor device may include a memory cell array region and a peripheral circuit region. The peripheral circuit region may include a first semiconductor element 200 and a second semiconductor element. Each of the first semiconductor element 200 and the second semiconductor element may include a substrate 203, a fin structure 205 extending on the substrate 203 in a first direction (X-axis direction), a gate structure 210 extending on the fin structure 205 in a second direction (Y-axis direction), a source region 220, and a drain region 230.

The first semiconductor element 200 may be an element operating by receiving a relatively high voltage, and the second semiconductor element may be an element operating by receiving a relatively low voltage. A source region and a drain region included in the first semiconductor element 200 may have different structures. For example, referring to FIGS. 6 to 8, the lower surface of the drain region 230 may be higher than the lower surface of the source region 220 in the third direction (Z-axis direction). Meanwhile, the source region and the drain region included in the second semiconductor element may have substantially the same structure based on the gate structure.

Referring to FIG. 6, in the first semiconductor element 200, active regions including the source region 220 and the drain region 230 may be formed in opposing sides of the fin structures 205 centered on the gate structure 210. The active regions including the source region 220 and the drain region 230 may be formed by removing the fin structures 205 and performing an epitaxial growth process. In an example embodiment, an etching process of the fin structures 205 for forming the source region 220 and the drain region 230 and an epitaxial growth process may be performed separately.

The first semiconductor element 200 may include a source region 220. In the third direction (Z-axis direction), the source region 220 may include a region extending downwardly from a lower surface of the gate structure 210. The source region 220 may include a region protruding in the first direction (X-axis direction) into a region extending downwardly from the lower surface of the gate structure 210. In the third direction (Z-axis direction), the source region 220 may include a region extending upwardly from the lower surface of the gate structure 210, and may overlap the gate structure 210 in the region.

The first semiconductor element 200 may include a drain region 230. In the third direction (Z-axis direction), the drain region 230 may include a region extending downwardly from the lower surface of the gate structure 210. In the third direction (Z-axis direction), the drain region 230 may have a region extending upwardly from the lower surface of the gate structure 210, and may overlap with the gate structure 210 in the region. The source region 220 and the drain region 230 may include a portion in which the source region 220 and the drain region 230 face each other with the fin structure 205 interposed therebetween in a lower portion of the gate structure 210.

Referring to FIG. 6, the source region 220 and the drain region 230 included in the first semiconductor element 200 according to an example embodiment of the present disclosure may have different shortest distances from the gate structure 210 in the first direction (X-axis direction). A shortest distance p2 between the gate structure 210 (e.g. the gate metal layer of the gate structure 210) and the drain region 230 in the first direction (X-axis direction) may be greater than a shortest distance p1 between the gate structure 210 (e.g. the gate metal layer of the gate structure 210) and the source region 220 in the first direction (X-axis direction). By removing the fin structures 205 to form the source region 220 and the drain region 230, the source region 220 may form a region protruding under the gate structure 210 in the first direction (X-axis direction) unlike the drain region 230, and the shortest distance p1 between the gate structure 210 and the source region 220 in the first direction (X-axis direction) may be less than the shortest distance p2 between the gate structure 210 and the drain region 230 in the first direction (X-axis direction).

Referring to FIG. 6, in the third direction (Z-axis direction), a lower surface of the drain region 230 may be above a lower surface of the source region 220, relative to a surface of the substrate 203 as a reference layer. A shortest distance d2 between the lower surface of the gate structure 210 and the lower surface of the drain region 230 in the third direction (Z-axis direction) may be less than a shortest distance d1 between the lower surface of the gate structure 210 and the lower surface of the source region 220 in the third direction (Z-axis direction). By removing each of the fin structures 205 to form the source region 220 and the drain region 230, the lower surface of the drain region 230 may be above the lower surface of the source region 220 in the third direction (Z-axis direction), and the shortest distance d1 between the lower surface of the gate structure 210 and the lower surface of the source region 220 and the shortest distance d2 between the lower surface of the gate structure 210 and the lower surface of the drain region 230 in the third direction may be different from each other.

In an example embodiment of the present disclosure, the epitaxial growth processes for forming the source region 220 and the drain region 230 may be performed separately. By performing the epitaxial growth processes separately, a thickness h1 of the source region 220 and a thickness h2 of the drain region 230 in the third direction (Z-axis direction) may not be identical to each other (i.e. may be different from each other). For example, the thickness h2 of the drain region 230 may be less than the thickness h1 of the source region 220. Since a removal process and an epitaxial growth process of the fin structures 205 are performed separately, the lower surface of the source region 220 may be below the lower surface of the drain region 230 in the third direction (Z-axis direction), relative to the surface of the substrate 203, and positions of the upper surfaces of the source region 220 and the drain region 230 may be substantially identical to each other; that is, the upper surfaces of the source region 220 and drain region 230 may be horizontally coplanar.

In an example embodiment of the present disclosure, the source region 220 and the drain region 230 included in the first semiconductor element 200 may have different structures in the first direction (X-axis direction) and the third direction (Z-axis direction). The first semiconductor element 200 having different structures in the source region 220 and the drain region 230 may reduce the electric field around the region in which the gate structure 210 and the drain region 230 overlap each other, as compared to the second semiconductor element in which the source region and the drain region have substantially the same structure. Since the source region 220 and the drain region 230 of the first semiconductor element 200 form different structures, the first semiconductor element 200 having improved characteristics such as the HCI and the GIDL may be provided, thereby improving the reliability of the first semiconductor element 200 to which a relatively high voltage is applied.

In an example embodiment of the present disclosure, the semiconductor device may include a memory cell array region and a peripheral circuit region. The peripheral circuit region may include a first semiconductor element 200a and a second semiconductor element. The first semiconductor element 200a may be an element that is operating by receiving a relatively high voltage, and a source region 220a and a drain region 230a included in the first semiconductor element 200a may have different structures.

Referring to FIG. 7, the first semiconductor element 200a may include a substrate 203a, a fin structure 205a extending in the first direction (X-axis direction) on the substrate 203a, a gate structure 210a extending in the second direction (Y-axis direction) on the fin structure 205a, and the source region 220a and the drain region 230a formed in the substrate 203a in opposing sides of the fin structure 205a.

The source region 220a included in the first semiconductor element 200a may be formed by removing the fin structure 205a and performing an epitaxial growth process. In the third direction (Z-axis direction), the source region 220a may include a region extending downwardly from a lower surface of the gate structure 210a. The source region 220a may include a region protruding in the first direction (X-axis direction) into a region extending downwardly from the lower surface of the gate structure 210a (i.e., under the gate structure 210a). In the third direction (Z-axis direction), the source region 220a may have a region extending upwardly from the lower surface of the gate structure 210a, and may overlap the gate structure 210a in the region.

The drain region 230a included in the first semiconductor element 200a may be formed by removing the fin structure 205a and performing an epitaxial growth process. In the third direction (Z-axis direction), the drain region 230a may include a region extending downwardly from the lower surface of the gate structure 210a. In the third direction (Z-axis direction), the drain region 230a has a region extending upwardly from the lower surface of the gate structure 210a, and may overlap the gate structure 230a in the region. The source region 220a and the drain region 230a may include a portion in which the source region 220a and the drain region 230a face each other with the fin structure 205a interposed therebetween in a lower portion of the gate structure 210a.

Referring to FIG. 7, the source region 220a and the drain region 230a included in the first semiconductor element 200a according to an example embodiment of the present disclosure may have different shortest distances from the gate structure 210a in the first direction (X-axis direction). A shortest distance p4 between the gate structure 210a (e.g. the gate metal layer of the gate structure 210a) and the drain region 230a in the first direction (X-axis direction) may be greater than a shortest distance p3 between the gate structure 210a (e.g. the gate metal layer of the gate structure 210a) and the source region 220an in the first direction (X-axis direction). By separately removing the fin structures 205a for forming the source region 220a and the drain region 230a, the source region 220a may have a protruding region in the first direction (X-axis direction), and the shortest distance p4 between the drain region 230a and the gate structure 210a in the first direction (X-axis direction) may be greater than the shortest distance p3 between the source region 220a and the gate structure 210a.

Referring to FIG. 7, a lower surface of the drain region 230a in the third direction (Z-axis direction) may be above a lower surface of the source region 220a. In other words, a shortest distance d4 between the lower surface of the gate structure 210a and the lower surface of the drain region 230a in the third direction (Z-axis direction) may be less than a shortest distance d3 between the lower surface of the gate structure 210a and the lower surface of the source region 220a.

Meanwhile, epitaxial growth processes for forming the source region 220a and the drain region 230a of the first semiconductor element 200a may be performed simultaneously. Since the epitaxial growth processes are performed simultaneously, a thickness h3 of the source region 220a and a thickness h4 of the drain region 230a in the third direction (Z-axis direction) may be substantially identical to each other. In an example embodiment, when widths of the source region 220a and the drain region 230a in the first direction (X-axis direction) are substantially identical to each other, sizes (i.e., areas) of the source region 220a and the drain region 230a may be substantially identical to each other.

In an example embodiment of the present disclosure, positions of the upper and lower surfaces of the source region 220a and the drain region 230a of the first semiconductor element 200a in the third direction (Z-axis direction) may be different from each other. For example, the positions of the upper and lower surfaces of the drain region 230a may be in a shape that further rises in the third direction than the positions of the upper and lower surfaces of the source region 220a. The source region 220a and the drain region 230a of the first semiconductor element 200a may have a structure in which the source region 220a and the drain region 230a are disposed differently from each other in the third direction (Z-axis direction) based on the gate structure 210a. An upper surface of the drain region 230a may be above an upper surface of the source region 220a in the third direction Z.

In an example embodiment of the present disclosure, the source region 220a and the drain region 230a included in the first semiconductor element 200a may have different structures, thereby reducing the electric field around the region in which the gate structure 210a and the drain region 230a overlap each other. Since the source region 220a and the drain region 230a of the first semiconductor element 200a have different structures, the first semiconductor element 200a has improved characteristics such as the HCI and the GIDL, thereby improving the reliability of the first semiconductor element 200a operating by receiving a relatively high voltage.

In an example embodiment of the present disclosure, the semiconductor device may include a memory cell array region and a peripheral circuit region. The peripheral circuit region may include the first semiconductor element 200b and the second semiconductor element. The first semiconductor element 200b may be an element operating by receiving a relatively high voltage, and a source region 220b and the drain region 230b included in the first semiconductor element 200b may have different structures.

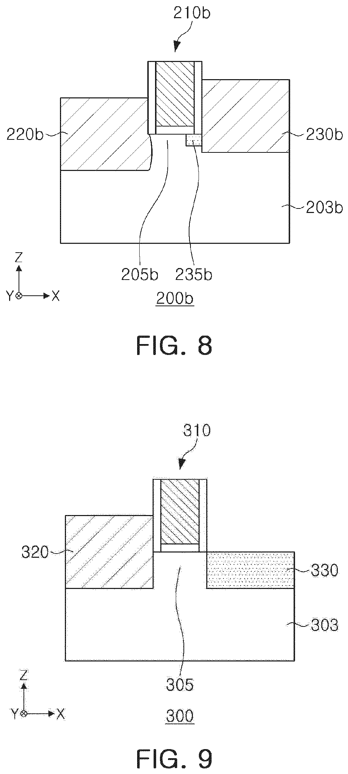

Referring to FIG. 8, the first semiconductor element 200b may include a substrate 203b, a fin structure 205b extending in the first direction (X-axis direction) on the substrate 203b, a gate structure 210b extending in the second direction (Y-axis direction) on the fin structure 205b, and a source region 220b and a drain region 230b formed in the substrate 203b in opposing sides of the fin structure 205b.

Referring to FIG. 8, the first semiconductor element 200b may include a source region 220b. In the third direction (Z-axis direction), the source region 220b may include a region extending downwardly from a lower surface of the gate structure 210b. The source region 220b may include a region protruding in the first direction (X-axis direction) into a region extending downwardly from the lower surface of the gate structure 210b. In the third direction (Z-axis direction), the source region 220b may have a region extending upwardly from the lower surface of the gate structure 210b, and may overlap the gate structure 210b in the region.

The first semiconductor element 200b may include the drain region 230b. In the third direction (Z-axis direction), the drain region 230b may include a region extending downwardly from the lower surface of the gate structure 210b. In the third direction (Z-axis direction), the drain region 230b may have a region extending upwardly from the lower surface of the gate structure 210b, and may overlap the gate structure 230b in the region. The source region 220b and the drain region 230b may include a portion in which the source region 220b and the drain region 230b face each other with the fin structure 205b interposed therebetween in a lower portion of the gate structure 210b.

Referring to FIG. 8, the drain region may include a first drain region 230b and a second drain region 235b disposed between the first drain region 230b and the gate structure 210b. The second drain region 235b may be disposed proximate a lower corner of the gate structure 210b and adjacent to a side of the first drain region 230b facing the gate structure 210b. The second drain region 235b may be doped at a lower concentration than a concentration of the first drain region 230b. For example, the second drain region 235b may be a Lightly Doped Drain (LDD) region. In order to form the second drain region 235b, a pad oxide pattern and a mask pattern may be formed on the source region 220b. The pad oxide pattern may be a layer provided to protect the source region 220b, and may be omitted according to example embodiments. The mask pattern is a mask layer for patterning a semiconductor element, and may include silicon nitride and carbon-containing material. The mask pattern may have a plurality of layers.

Referring to FIG. 8, the first and second drain regions 230b and 235b included in the first semiconductor element 200b may have a different structure from the source region 220b. The drain regions 230b and 235b may include the first drain region 230b and the second drain region 235b, and the source region 220b may include a region protruding in the first direction (X-axis direction) in the lower portion of the gate structure 210b. Specifically, the drain region may include the second drain region 235b, thus reducing the electric field around a region in which the gate structure 210b and the drain regions 230b and 235b overlap each other. Since the source region 220b and the drain regions 230b and 235b of the first semiconductor element 200b have different structures, the semiconductor element having improved characteristics such as the HCI and the GIDL may be provided, thereby improving the reliability of the first semiconductor element 200b.

In an example embodiment of the present disclosure, the semiconductor device may include a memory cell array region and a peripheral circuit region. The peripheral circuit region may include a first semiconductor element 300 and a second semiconductor element. The first semiconductor element 300 may be an element operating by receiving a relatively high voltage, and a source region 320 and a drain region 330 included in the first semiconductor element 300 may have different structures.

Referring to FIG. 9, the first semiconductor element 300 may include a substrate 303, a fin structure 305 extending on the substrate 303 in the first direction (X-axis direction), a gate structure 310 extending on the fin structure 305 in the second direction (Y-axis direction), and a source region 320 and a drain region 330 formed in the substrate 303 in opposing sides of the fin structure 305. The source region 320 and the drain region 330 may be doped with first conductivity type impurities.

The source region 320 included in the first semiconductor element 300 may be formed by removing the fin structure 305 and performing an epitaxial growth process thereon. In the third direction (Z-axis direction), the source region 320 may include a region extending downwardly from a lower surface of the gate structure 310. However, the source region 320 is not limited thereto, in some embodiments (not explicitly shown), the source region 320 may include a region protruding in the first direction (X-axis direction), in the lower surface of the gate structure 310. In the third direction (Z-axis direction), the source region 320 may have a region extending upwardly from the lower surface of the gate structure 310 and may overlap the gate structure 310 in the region.

The drain region 330 included in the first semiconductor element 300 may be formed by implanting ions into the fin structure 305. For example, the drain region 330 may be formed by implanting first conductivity type impurities into the fin structure 305. The drain region 330 may include a region extending downwardly from the lower surface of the gate structure 310 in the third direction (Z-axis direction). The source region 320 and the drain region 330 may include a portion in which the source region 320 and the drain region 330 face each other with the fin structure 305 interposed therebetween in a lower portion of the gate structure 310.

In an example embodiment, positions of an upper surface of the drain region 330 and an upper surface of the source region 320 in the third direction may not be identical to each other. Since the source region 320 is epitaxially grown after removing the fin structure 305, the upper surface of the source region 320 may be higher than the lower surface of the gate structure 310 in the third direction (Z-axis direction). Since the drain region 330 does not remove the fin structure 305, the upper surface of the drain region 330 may be substantially identical to the lower surface of the gate structure 310, relative to a surface of the substrate 303 as a reference layer. Accordingly, the upper surface of the drain region 330 may be lower than the upper surface of the source region 320 in the third direction (Z-axis direction).

In an example embodiment, the drain region 330 may be doped with the first conductivity type impurities at least once. The drain region 330 may be doped at least once by varying at least one of the energy, the concentration, and the angle for injecting the first conductivity type impurities. Doping operations may be performed multiple times with different energies, different concentrations, and different angles for injecting the first conductivity type impurities into the drain region 330, thereby reducing the electric field around a region in which the gate structure 310 and the drain region 330 overlap each other.

Referring to FIG. 9, the source region 320 and the drain region 330 included in the first semiconductor element 300 may have different structures, such as whether or not the fin structure 305 is removed, and a position of an upper surface thereof in the third direction (Z-axis direction). The source region 320 and the drain region 330 may have different structures, thus reducing the electric field around the region in which the gate structure 310 and the drain region 330 overlap each other. Since the source region 320 and the drain region 330 of the first semiconductor element 300 have different structures, a semiconductor element having improved characteristics of as HCI and GIDL may be provided, thereby improving the reliability of the first semiconductor element 300.

In an example embodiment of the present disclosure, the semiconductor device may include a memory cell array region and a peripheral circuit region. The peripheral circuit region may include a first semiconductor element 300a and a second semiconductor element. The first semiconductor element 300a may be an element operating by receiving a relatively high voltage, and a source region 320a and a drain region 330a included in the first semiconductor element 300a may have different structures.

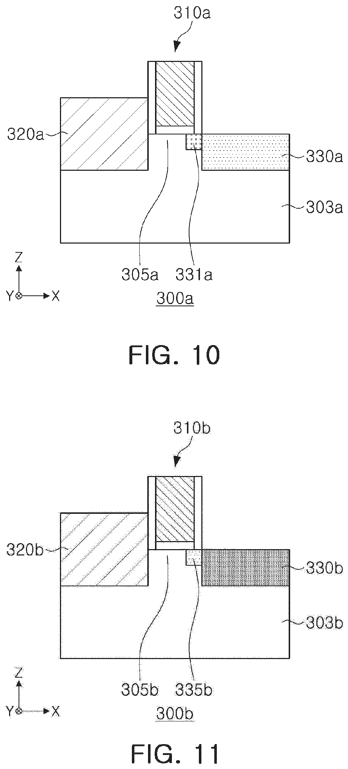

Referring to FIG. 10, the first semiconductor element 300a may include a substrate 303a, a fin structure 305a extending in the first direction (X-axis direction) on the substrate 303a, a gate structure 310a extending in the second direction (Y-axis direction) on the fin structure 305a, and a source region 320a and a drain region 330a formed in the substrate 303a in opposing sides of the fin structure 305a.

In an example embodiment of the present disclosure, the source region 320a and the drain region 330a included in the first semiconductor element 300a may be formed respectively. The source region 320a may be formed by performing an epitaxial growth process after removing the fin structures 305a. The drain region 330a may be formed by directly injecting the first conductivity type impurities into the fin structures 305a without removing the fin structures 305a.

The source region 320a included in the first semiconductor element 300a may be formed by removing the fin structures 305a and performing an epitaxial growth process thereon. In the third direction (Z-axis direction), the source region 320a may include a region extending downwardly from a lower surface of the gate structure 310a. However, the source region 320 is not limited thereto, in some embodiments (not explicitly shown), the source region 320a may include a region protruding in the first direction (X-axis direction) into the lower surface of the gate structure 310a. In the third direction (Z-axis direction), the source region 320a may have a region extending upwardly from the lower surface of the gate structure 310a, and may overlap the gate structure 310a in the region.

The drain region 330a included in the first semiconductor element 300a may be formed by injecting ions into the fin structure 305a. For example, the drain region 330a may be formed by injecting the first conductivity type impurities into the fin structure 305a. The drain region 330a may include a region extending downwardly from the lower surface of the gate structure 310a in the third direction (Z-axis direction). The source region 320a and the drain region 330a may include a portion in which the source region 320a and the drain region 330a face each other with the fin structure 305a interposed therebetween in the lower portion of the gate structure 310a.

Referring to FIG. 10, the first semiconductor element 300a may include a counter doping region 331a doped with the first conductivity type impurities and the second conductivity type impurities between the gate structure 310a and the drain region 330a. The counter doping region 331a may be in direct contact with the drain region 330a and the gate structure 310a. Counter doping refers to intentionally doping impurities to control electrical characteristics when manufacturing a semiconductor element, and the impurities may vary depending on the type of semiconductor. In order to prevent entire characteristics of the semiconductor element from being deteriorated due to the counter doping, the counter doping region 331a may be formed only in a portion between the gate structure 310a and the drain region 330a (e.g., at a lower corner of the gate structure 310a adjacent to the drain region 330a).

In an example embodiment of the present disclosure, the first semiconductor device 300a may form the counter doping region 331a between the gate structure 310a and the drain region 330a, so that the drain region 330a and the source region 320a may have different structures. The counter doping region 331a may be formed, thus improving a breakdown voltage of the first semiconductor element 300a as well as reducing the electric field around a region in which the gate structure 310a and the drain region 330a overlap each other. Since the source region 320a and the drain region 330a of the first semiconductor element 300a have different structures, the semiconductor element having improved characteristics such as the HCI and the GIDL, thereby improving the reliability of the first semiconductor element 300a.

In an example embodiment of the present disclosure, the semiconductor device may include a memory cell array region and a peripheral circuit region. The peripheral circuit region may include a first semiconductor element 300b and a second semiconductor element. The first semiconductor element 300b may be an element operating by receiving a relatively high voltage, and a source region 320b and a drain region 330b included in the first semiconductor element 300b may have different structures.

Referring to FIG. 11, the first semiconductor element 300b may include a substrate 303b, a fin structure 305b extending on the substrate 303b in the first direction (X-axis direction), a gate structure 310b extending on the fin structure 305b in a second direction (Y-axis direction), and the source region 320b and the drain region 330b formed in the substrate 303b in opposing sides of the fin structure 305b. The source region 320b and the drain region 330b may be doped with the first conductivity type impurities.

In an example embodiment of the present disclosure, the source region 320b and the drain region 330b included in the semiconductor element 300b may be formed respectively. The source region 320a may be formed by performing an epitaxial growth process after removing the fin structures 305b. The drain region 330b may be formed by directly injecting the first conductivity type impurities into the fin structures 305a without removing the fin structures 305b.

The drain region may include the first drain region 330b and a second drain region 335b disposed between the first drain region 330b and the gate structure 310b. The second drain region 335b may be doped with the first conductivity type impurities at a lower concentration than a concentration of the first drain region 330b. For example, the second drain region 335b may be a Lightly Doped Drain (LDD) region. Additionally, the first drain region 330b may be doped with first conductivity impurities having a concentration higher than a concentration of the second drain region 335b. The first drain region 330b may be a Highly Doped Drain (HDD) region.

The first drain region 330b may be doped with a relatively high concentration of first conductivity impurities and the second drain region 335b may be doped with a relatively low concentration of first conductivity impurities, thus reducing the electric field around a region in which the gate structure 310b and the first drain region 330b overlap each other. Since the source region 320b and the drain regions 330b and 335b of the first semiconductor element 300b have different structures, the semiconductor element 300b having improved characteristics such as the HCI and the GIDL may be provided, thereby improving the reliability of the first semiconductor element 300b.

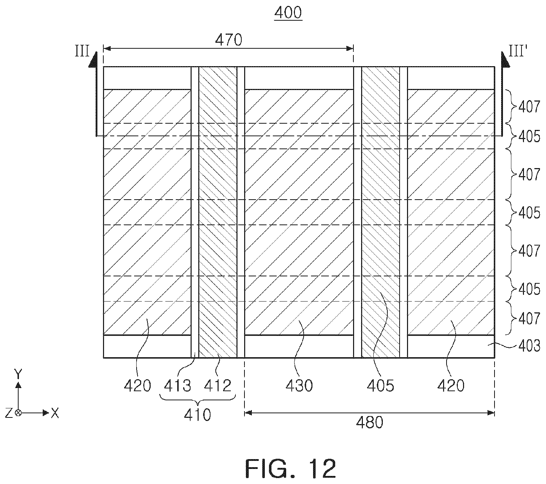

FIG. 12 is a schematic plan view simply illustrating an element region according to an example embodiment of the present disclosure.

A semiconductor device according to an example embodiment of the present disclosure may include an element region 400 in a peripheral circuit region. The element region 400 may include an NMOS region and/or a PMOS region. In an example embodiment, the element region 400 may include semiconductor elements driven by receiving a relatively high voltage.

The element region 400 may include a first semiconductor element 470 and a second semiconductor element 480. In an example embodiment, a sub-word line driver may include the first semiconductor element 470 and the second semiconductor element 480. Referring to FIG. 3 as an example together with FIG. 12, the first semiconductor element 470 may be a first NMOS transistor 70 of the sub-word line driver SWD, and the second semiconductor element 480 may be a second NMOS transistor 80 of the sub-word line driver SWD.

The element region 400 may include a substrate 403 having a plurality of fin structures 405, active regions provided on the substrate 403 to provide a source region 420 and a drain region 430, and a gate structure 410 disposed between the active regions and extending in the second direction (Y-axis direction) to intersect the plurality of fin structures 405. The active regions may be formed of silicon (Si), and may be doped with, for example, N-type impurities such as phosphorus (P), nitrogen (N), arsenic (As), or antimony (Sb), although embodiments are not limited thereto.

The substrate 403 may be a base on which a semiconductor element is manufactured, and may include a well region. The substrate 403 may have a recessed region partially removed from an upper surface thereof. The substrate 403 may be provided as a bulk wafer, an epitaxial layer, a silicon on insulator (SOI) layer, or a semiconductor on insulator (SeOI) layer. The substrate 403 may include a semiconductor material, such as a group IV semiconductor, a group III-V compound semiconductor, or a group II-VI compound semiconductor. For example, the group IV semiconductor may include silicon, germanium, or silicon germanium. The substrate 403 may include first conductivity impurities, such as P-type impurities, but the present disclosure is not limited thereto.

The element region 400 may include the plurality of fin structures 405 extending in the first direction (X-axis direction) on the substrate 403, and the gate structure 410 extending in the second direction (Y-axis direction) to intersect the plurality of fin structures 405. The plurality of fin structures 405 may be formed to protrude in the third direction (Z-axis direction) from an upper surface of the substrate 403, and may have a fin structure.

The active region may include a base active region and a plurality of fin structures 405. The plurality of fin structures 405 may include impurities. The plurality of fin structures 405 may be separated by an element isolating film 407 in the substrate, and may extend in the first direction (X-axis direction). Adjacent fin structures 405 may be spaced apart from each other in the second direction (Y-axis direction) by the element isolating film 407 therebetween. The plurality of fin structures 405 may be spaced apart from the element isolating film 407 in the second direction (Y-axis direction). The element isolating film 407 may include an insulating material such as silicon oxide, silicon nitride, or silicon oxide.

In order to form the source region 420 and the drain region 430, the plurality of fin structures 405 on both (i.e., opposing) sides of the gate structure 410 may be removed. The source region 420 and the drain region 430 may be formed by applying a selective epitaxial growth process to the plurality of removed fin structures 405.

The gate structure 410 may include a gate insulating layer and a gate metal layer 412. The gate structure 410 may extend in the second direction (Y-axis direction), and may intersect with the plurality of fin structures 405 extending in the first direction (X-axis direction), intersecting with the second direction. The gate spacers 413 may be formed on each side surface of the gate metal layer 412.

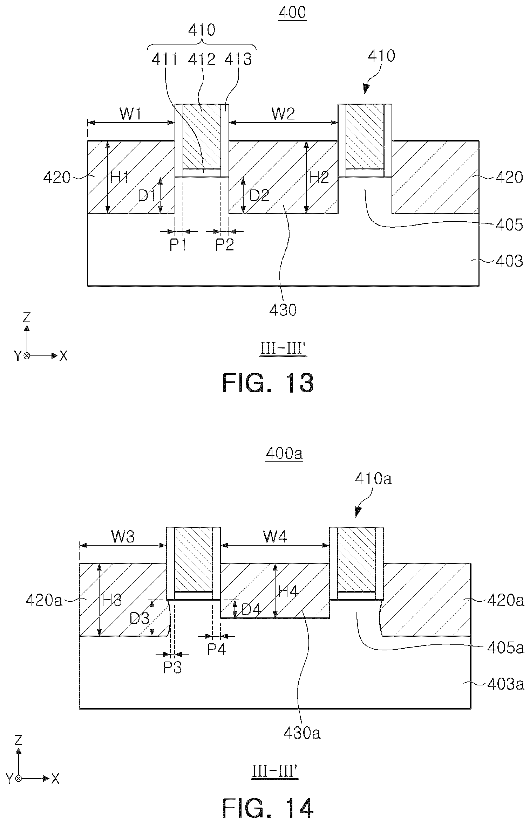

FIGS. 13 to 16 are schematic cross-sectional views illustrating cross-sections taken along line III-III' of FIG. 12, according to embodiments of the present disclosure.

Referring to FIG. 13, the element region 400 may include a substrate 403, a plurality of fin structures 405 extending in the first direction (X-axis direction) on the substrate 403, and a gate structure 410 extending on the plurality of fin structures 405 in the second direction (Y-axis direction). In an example embodiment, the element region 400 may include semiconductor elements driven by a relatively high voltage, and may be included in the word line driver. In an example embodiment, etching processes of the fin structures 405 for forming a source region 420 and a drain region 430 may be performed simultaneously, and epitaxial growth processes thereof may be performed separately.

In an example embodiment of the present disclosure, the source region 420 may include a region extending downwardly from a lower surface of the gate structure 410 in the third direction (Z-axis direction). Additionally, the source region 420 may include a region extending upwardly from the lower surface of the gate structure 410 in the third direction, and may overlap the gate structure 410 in the region.

In an example embodiment of the present disclosure, the drain region 430 may include a region extending downwardly from the lower surface of the gate structure 410 in the third direction (Z-axis direction). Additionally, the drain region 430 may include a region extending upwardly from the lower surface of the gate structure 410, and may overlap the gate structure 410 in the region. Meanwhile, a width W2 of the drain region 430 in the first direction (X-axis direction) may be greater than a width W1 of the source region 420 in the first direction (X-axis direction).

In an example embodiment of the present disclosure, a plurality of fin structures 405 for forming the source region 420 and the drain region 430 may be removed simultaneously. Since the plurality of fin structures 405 are removed simultaneously, a shortest distance P1 between the gate structure 410 (e.g. the gate metal layer 412 of the gate structure 410) and the source region 420 and a shortest distance P2 between the gate structure 410 (e.g. the gate metal layer 412 of the gate structure 410) and the drain region 430 in the first direction (X-axis direction) may be substantially identical to each other. Additionally, a shortest distance D1 between the lower surface of the gate structure 410 and the source region 420 in the third direction (Z-axis direction) and a shortest distance D2 between the lower surface of the gate structure 410 and the drain region 430 may be substantially identical to each other. Additionally, positions of the lower surface of the source region 420 and the lower surface of the drain region 430 in the third direction may be substantially identical to each other.

Meanwhile, epitaxial growth processes for forming the source region 420 and the drain region 430 included in the element region 400 may be performed separately. The epitaxial growth processes may be performed separately, so that a thickness H1 of the source region 420 and a thickness H2 of the drain region 430 may be made identical to each other in the third direction (Z-axis direction). Additionally, positions of an upper surface of the source region 420 and an upper surface of the drain region 430 in the third direction (Z-axis direction) may be substantially identical to each other. However, since the width W2 of the drain region 430 in the first direction (X-axis direction) may be greater than the width W1 of the source region 420, sizes of the source region 420 and the drain region 430 may be different from each other. For example, the size of the drain region 430 may be greater than the size of the source region 420.

Referring to FIG. 13, the source region 420 and the drain region 430 included in the element region 400 may have different structures having different width lengths and different region sizes in the first direction. Since the source region 420 and the drain region 430 included in the element region 400 have different structures, the electric field around the region in which the gate structure 410 and the drain region 430 overlap each other may be reduced. Since the source region 420 and the drain region 430 of the semiconductor element have different structures, the semiconductor element having improved characteristics such as the HCI and the GIDL may be provided, thereby improving the reliability of the semiconductor element.

Referring to FIG. 14, an element region 400a may include a substrate 403a, a plurality of fin structures 405a extending on the substrate 403a in the first direction (X-axis direction), and gate structures 410a extending on the respective plurality of fin structures 405a in a second direction (Y-axis direction). In an example embodiment, the element region 400a may include semiconductor elements driven by a relatively high voltage, and may be included in the word line driver. The fin structures 405a may be removed, respectively, to form a source region 420a and a drain region 430a, and epitaxial growth processes thereof may be performed simultaneously.

In an example embodiment of the present disclosure, the source region 420a may include a region extending downwardly from a lower surface of the gate structure 410a in a third direction (Z-axis direction). In the lower surface of the gate structure 410a, the source region 420a may include a region protruding in the first direction (X-axis direction) (i.e., under the gate structure 410a). Additionally, the source region 420a may include a region extending upwardly from the lower surface of the gate structure 410a in the third direction (Z-axis direction), and may overlap the gate structure 410a in the region.

In an example embodiment of the present disclosure, the drain region 430a may include a region extending downwardly from the lower surface of the gate structure 410a in the third direction (Z-axis direction). Additionally, the drain region 430a may include a region extending upwardly from the lower surface of the gate structure 410a, and may overlap the gate structure 410a in the region. Meanwhile, a width W4 of the drain region 430a in the first direction (X-axis direction) may be greater than a width W3 of the source region 420a in the first direction (X-axis direction).

The plurality of fin structures 405a for forming the source region 420a and the drain region 430a may be removed separately. Since the plurality of fin structures 405a are removed separately, a shortest distance P4 between the gate structure 410a (e.g. the gate metal layer of the gate structure 410a) and the drain region 430a in the first direction (X-axis direction) may be greater than a shortest distance P3 between the gate structure 410a (e.g. the gate metal layer of the gate structure 410a) and the source region 420a. Additionally, a shortest distance D4 between the lower surfaces of the gate structure 410a and the drain region 430a in the third direction (Z-axis direction) may be less than a shortest distance D3 between the gate structure 410a and the source region 420a.

Meanwhile, epitaxial growth processes for forming the source region 420a and the drain region 430a may be performed simultaneously. Since the width W4 of the drain region 430a in the first direction (X-axis direction) is wider than the width W3 of the source region 420a, when the epitaxial growth processes of the source region 420a and the drain region 430a is performed simultaneously, a thickness H4 of the drain region 430a in the third direction (Z-axis direction) may be different from a thickness H3 of the source region 420a. For example, the thickness H4 of the drain region 430a in the third direction may be less than the thickness H3 of the source region 420a. Even if the thickness H4 of the drain region 430a is less than the thickness H3 of the source region 420a, since the width W4 of the drain region 430a is wider than the width W3 of the source region 420a, a size (i.e., area or volume) of the drain region 430a may be greater than a size of the source region 420a. In an example embodiment, positions of an upper surface of the source region 420a and an upper surface of the drain region 430a in the third direction may be substantially identical to each other.

Referring to FIG. 14, the source region 420a and the drain region 430a included in the element region 400a may have structures having different width lengths and different region sizes. Since the source region 420a and the drain region 430a have different structures, the electric field around a region in which the gate structure 410a and the drain region 430a overlap each other. Since the source region 420a and the drain region 430a of the semiconductor element have different structures, the semiconductor device having improved characteristics such as the HCI and the GIDL may be provided, thereby improving the reliability of the semiconductor element.

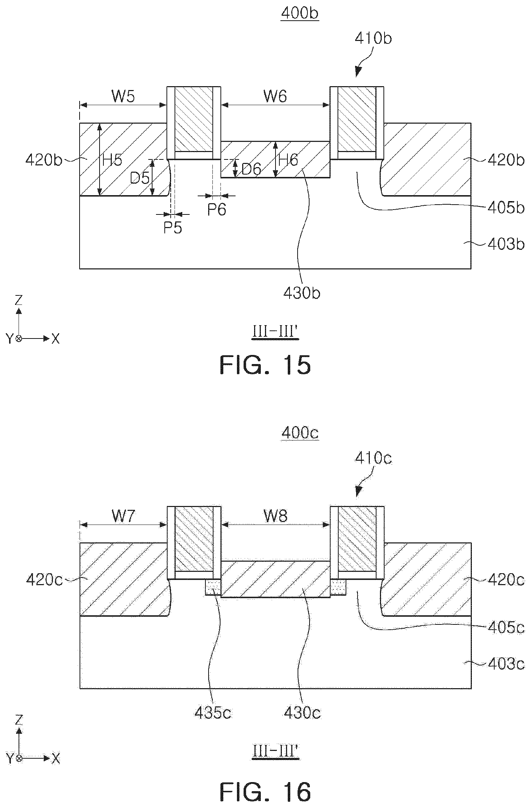

Referring to FIG. 15, an element region 400b may include a substrate 403b, a plurality of fin structures 405b extending on the substrate 403b in the first direction (X-axis direction), and a gate structure 410b extending on the plurality of fin structures 405b in a second direction (Y-axis direction). In an example embodiment of the present disclosure, a width W6 of a drain region 430b in the first direction (X-axis direction) may be greater than a width W5 of a source region 420b. An etching process and an epitaxial growth process for forming the source region 420b and the drain region 430b may be performed separately.

In an example embodiment of the present disclosure, the source region 420b may include a region extending downwardly from a lower surface of the gate structure 410b in the third direction (Z-axis direction). In the lower surface of the gate structure 410b, the source region 420b may include a region protruding in the first direction (X-axis direction). Additionally, the source region 420b may include a region extending upwardly from the lower surface of the gate structure 410b in the third direction (Z-axis direction), and may overlap the gate structure 410b in the region.

In an example embodiment of the present disclosure, the drain region 430b may include a region extending downwardly from the lower surface of the gate structure 410b in the third direction (Z-axis direction). Additionally, the drain region 430b may include a region extending upwardly from the lower surface of the gate structure 410b, and may overlap with the gate structure 410b in the region. Meanwhile, the width W6 of the drain region 430b in the first direction (X-axis direction) may be greater than the width W5 of the source region 420b.

Since etching processes for forming the source region 420b and the drain region 430b are performed separately, a shortest distance P6 between the gate structure 410b (e.g. the gate metal layer of the gate structure 410b) and the drain region 430b in the first direction (X-axis direction) may be greater than a shortest distance P5 between the gate structure 410b (e.g. the gate metal layer of the gate structure 410b) and the source region 420b. Additionally, a shortest distance D6 between the lower surfaces of the gate structure 410b and the drain region 430b in the third direction (Z-axis direction) may be less than a shortest distance D5 between the lower surfaces of the gate structure 410b and the source region 420b.

Since epitaxial growth processes for forming the source region 420b and the drain region 430b is also performed separately, a thickness H6 of the drain region 430b and a thickness H5 of the source region 420b in the third direction (Z-axis direction) may be different. For example, the thickness H6 of the drain region 430b may be less than the thickness H5 of the source region 420b. Additionally, positions of upper and lower surfaces of the source region 420b and the drain region 430b in the third direction (Z-axis direction) may be different from each other, respectively. For example, in the third direction, the upper surface of the drain region 430b may be below the upper surface of the source region 420b, and the lower surface of the drain region 430b may be above the lower surface of the source region 420b.

Referring to FIG. 15, the source region 420b and the drain region 430b included in the element region 400b may have structures having different widths in the first direction (X-axis direction) and different thicknesses in the third direction (Z-axis direction). Since the source region 420b and the drain region 430b have different structures, the electric field around a region in which the gate structure 410b and the drain region 430b overlap each other may be reduced. Since the source region 420b and the drain region 430b of the semiconductor element have different structures, the semiconductor element having improved characteristics such as the HCI and the GIDL may be provided, thereby improving the reliability of the semiconductor element.

Referring to FIG. 16, an element region 400c may include a substrate 403c, a plurality of fin structures 405c extending on the substrate 403c in the first direction (X-axis direction), and a gate structure 410c extending in the second direction (Y-axis direction). In an example embodiment, a width W8 of a drain region 430c in the first direction (X-axis direction) may be greater than a width W7 of a source region 420c in the first direction.

In an example embodiment of the present disclosure, the source region 420c may include a region extending downwardly from a lower surface of the gate structure 410c in the third direction (Z-axis direction). In the lower surface of the gate structure 410c, the source region 420c may include a region protruding in the first direction (X-axis direction) (i.e., partially under the gate structure 410c). Additionally, the source region 420c may include a region extending upwardly from the lower surface of the gate structure 410c in the third direction (Z-axis direction), and may overlap the gate structure 410c in the region.

In an example embodiment of the present disclosure, the drain region 430c may include a region extending downwardly from the lower surface of the gate structure 410c in the third direction. Additionally, the drain region 430c may include a region extending upwardly from the lower surface of the gate structure 410c, and may overlap with the gate structure 410c in the region. Meanwhile, the width W8 of the drain region 430c in the first direction (X-axis direction) may be greater than the width W7 of the source region 420c.

Referring to FIG. 16, the drain region may include a first drain region 430c, and a second drain region 435c disposed between the first drain region 430c and the lower surface of the gate structure 410c. The second drain region 435c may be doped at a relatively lower concentration relative to a doping concentration of the first drain region 430c. The second drain region 435c may be an LDD region.

The source region 420c and the drain regions 430c and 435c included in the element region 400c according to an example embodiment of the present disclosure may have a structure having different presence or absence of the LDD region. Since the source region 420c and the drain region 430c and 435c have different structures, the electric field around a region in which the gate structure 410c and the drain region 430c and 435c overlap each other may be reduced. Since the source region 420c and the drain region 430c and 435c of the semiconductor element have different structures, the semiconductor element having improved characteristics such as the HCI and the GIDL may be provided, thereby improving the reliability of the semiconductor element.

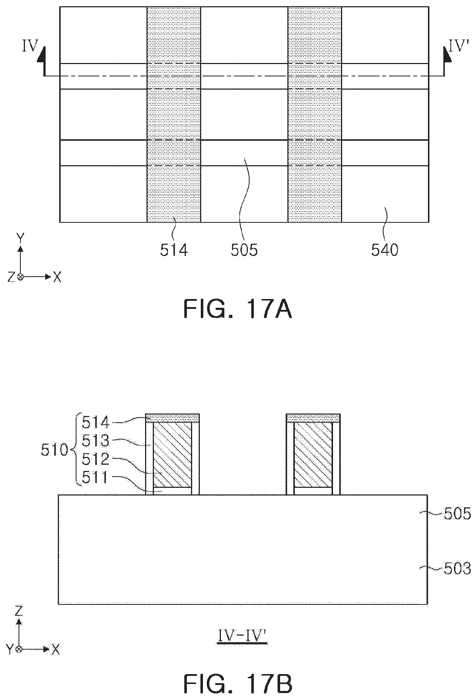

FIGS. 17A to 20B are schematic views illustrating intermediate processes in a method of manufacturing a semiconductor device according to an example embodiment of the present disclosure.

Referring to FIGS. 17A and 17B together, a semiconductor device may include a substrate 503, a plurality of fin structures 505 extending on the substrate 503 in a first direction (X-axis direction), and one or more dummy gate structures 510 extending in a second direction (Y-axis direction). In the first direction (X-axis direction), the dummy gate structures 510 and the active region may be spaced apart from each other. In the second direction (Y-axis direction), the plurality of fin structures 505 and an element isolating film 540 may be spaced apart from each other. The plurality of fin structures 505 may provide an active region of the semiconductor element.

The semiconductor device may include the substrate 503, the plurality of fin structures 505 on the substrate 503, and the one or more dummy gate structure 510 on the respective plurality of fin structures 505. Upper surfaces of the plurality of fin structures 505 may be parallel to lower surfaces of the dummy gate structures 510.

Each of the dummy gate structures 510 may include a dummy gate insulating layer 511 on the fin structure 505, a dummy gate metal layer 512, and a mask pattern layer 514. The dummy gate insulating layer 511 and the dummy gate metal layer 512 may be formed by an etching process using the mask pattern layer 514. The dummy gate insulating layer 511 may be formed of silicon oxide, and the dummy gate metal layer 512 may be formed of polysilicon.

The dummy gate structure 510 may further include a gate spacer 513 which may be formed by forming a film with an insulating material on upper portions of the dummy gate structure 510, the plurality of fin structures 505 and the element isolating film 540 and then anisotropically etching on the film thereof. The gate spacer 513 may include, for example, silicon oxide, silicon nitride or silicon oxynitride.

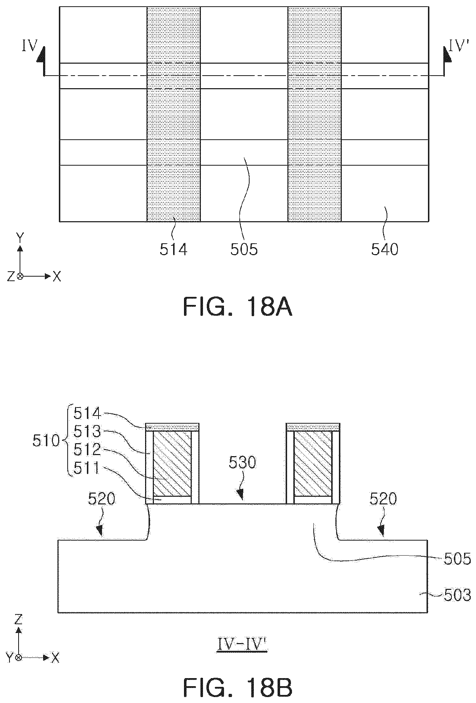

Referring to FIGS. 18A and 18B together, the plurality of fin structures 505 may be selectively removed from a first side (520) of the dummy gate structure 510. This portion may be a source region of the semiconductor element. In order to remove only the first side (520) of the dummy gate structure 510, a mask pattern may be separately formed on a second side (530) of the dummy gate structure 510. The mask pattern may be a layer provided to protect the second side (530) of the dummy gate structure 510, and may include silicon nitride, or carbon-containing materials.

A recess may be formed by removing the fin structures 505 from the first side (520) of the dummy gate structure 510. The recess may be formed by forming a mask layer separately or etching the fin structures 505 using the mask pattern layer 514 and the gate spacer 513 as a mask. In an example embodiment, the recess may be formed by sequentially applying a dry etching process and a wet etching process.

Optionally, after the formation of the recess, a process of curing a surface of the recessed fin structures 505 through a separate process may be performed. An upper surface of the recessed fin structures 505 may be lower than a lower surface of the dummy gate structure 510, but the present disclosure is not necessarily limited thereto. In another example embodiment, the upper surface of the recessed fin structures 505 may form a co-planar surface with the lower surface of the dummy gate structure 510.

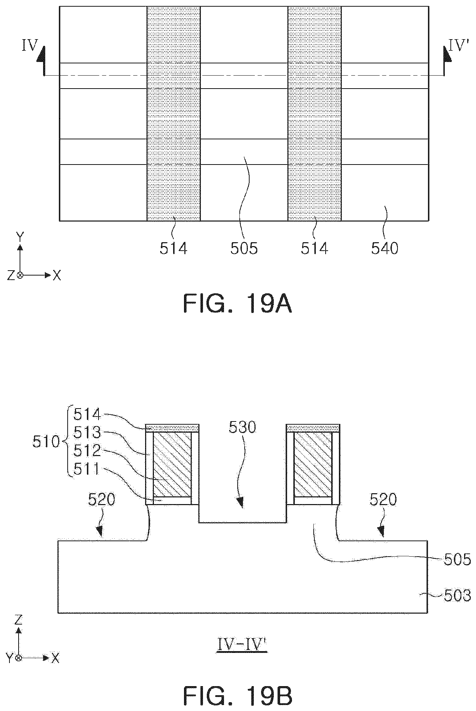

Referring to FIGS. 19A and 19B together, the plurality of fin structures 505 may be selectively removed from the second side (530) of the dummy gate structure 510. This portion may be a drain region of a semiconductor element. In order to remove only the second side (530) of the dummy gate structure 510, a mask pattern may be formed separately on the first side (520) of the dummy gate structure 510.

The recess may be formed by removing the fin structures 505 from the second side (530) of the dummy gate structure 510. A process of removing the fin structures 505 from the second side (530) of the dummy gate structure 510 may be the same as the process of removing the first side (520) of the dummy gate structure 510.

As described above, the process of removing the fin structures 505 in the portions that will become a source region 520 and a drain region 530 of the semiconductor element may be performed separately. The fin structures 505 may be removed so that the shortest distance between the portions that will become the dummy gate structure 510 and the drain region 530 in the first direction may be greater than the shortest distance between the portions that will become the dummy gate structure 510 and the source region 520. Additionally, the fin structures 505 may be removed so that the shortest distance between the portions that will become the dummy gate structure 510 and the drain region 530 in the third direction may be less than the shortest distance between the portions that will become the dummy gate structure 510 and the source region 520. Accordingly, the portions that will become the source region 520 and the drain region 530 of the semiconductor element may have different structures.

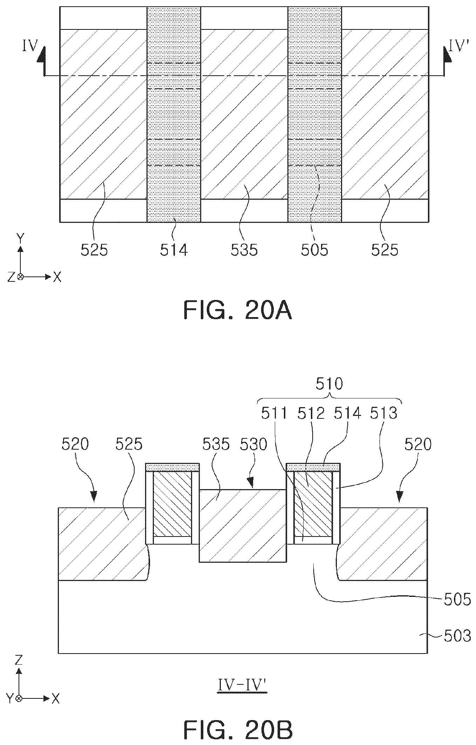

Referring to FIGS. 20A and 20B together, active regions 525 and 535 may be formed using fin structures 505. The active regions 525 and 535 may be formed by applying a selective epitaxial growth process to the fin structures 505 included in the NMOS region. In an example embodiment, the epitaxial growth processes for forming the source region 520 and the drain region 530 may be performed simultaneously.

When performing the epitaxial growth processes for each of the source region 520 and the drain region 530, a capping layer may be formed to cover the active regions. The capping layer may include an insulating material such as silicon oxide or silicon nitride.

The active regions 525 and 535 formed in the NMOS region may include silicon (Si). When forming the active regions 525 and 535 in the NMOS region, N-type impurities may be doped in-situ or doped by a separate ion implantation process. The N-type impurities doped in the active regions 525 and 535 may be phosphorus (P), nitrogen (N), arsenic (As), or antimony (Sb), although embodiments are not limited thereto.

Referring to FIG. 20B, the source region 520 and the drain region 530 included in the semiconductor element may have different structures. The shortest distance between the dummy gate structure 510 and the source region 520 and the drain region 530 in the first direction (X-axis direction), and the shortest distance between the dummy gate structure 510 and the source region 520 and the drain region 530 in the third direction (Z-axis direction) may be different from each other. Since the source region 520 and the drain region 530 of the semiconductor element have different structures, the electric field around a region in which the gate structure and the drain region 530 overlap each other may be reduced. Since the source region 520 and the drain region 530 of the semiconductor element have different structures, the semiconductor element having improved characteristics such as the HCI and the GIDL may be provided, thereby improving the reliability of the semiconductor element.

Various advantages and effects of the present inventive concept are not limited to the above-described contents, and will be more easily understood in the process of explaining specific embodiments.

While example embodiments have been illustrated and described above, it will be apparent to those skilled in the art that modifications and variations could be made without departing from the scope of the present inventive concept as defined by the appended claims.

## Claims

1. A semiconductor device, comprising:
a memory cell array region including a plurality of memory cells (MC) connected to a plurality of word lines (WL) and a plurality of bit lines (BL); and
a peripheral circuit region including a first semiconductor element (170a) and a second semiconductor element (170b),
wherein each of the first semiconductor element (170a) and the second semiconductor element (170b) includes:
a substrate (103a; 103b);
a fin structure (105a; 105b) extending on the substrate (103a;103b) in a first direction (X) parallel to a surface of the substrate (103a; 103b);
a gate structure (110a; 110b) extending on the fin structure (105a; 105b) in a second direction (Y), parallel to the surface of the substrate (103a; 103b) and perpendicular to the first direction (X), and including a gate dielectric layer (111a, 113a; 111b, 113b) and a gate metal layer (112a; 112b); and
a source region (120a; 120b) and a drain region (130a; 130b) in the substrate (103a; 103b) at opposing ends of the fin structure (105a; 105b) and spaced apart from each other in the first direction (X),
wherein a thickness, in a third direction (Z) perpendicular to the surface of the substrate (103a; 103b), of the gate dielectric layer (111a) included in the first semiconductor element (170a) is greater than a thickness of the gate dielectric layer (111b) included in the second semiconductor element (170b), and
the source region (120a) and the drain region (130a) included in the first semiconductor element (170a) are doped with first conductivity type impurities and have different structures.

2. The semiconductor device of claim 1,
wherein the peripheral circuit region includes a sub-word line driver (SWD) and a sense amplifier (BLSA),
the sub-word line driver (SWD) includes the first semiconductor element (170a), and
the sense amplifier (BLSA) includes the second semiconductor element (170b).

3. The semiconductor device of claim 1 or 2,
wherein in the first semiconductor element (170a), a doping concentration of the drain region (130a) is lower than a doping concentration of the source region (120a).

4. The semiconductor device of any one of claims 1 to 3,
wherein the source region (220) included in the first semiconductor element (200) includes a region protruding in the first direction (X) and at least partially overlapping a lower surface of the gate structure (210) in the third direction (Z).

5. The semiconductor device of any one of claims 1 to 4,
wherein in the first semiconductor element (200), a shortest distance (p2) between the gate metal layer of the gate structure (210) and the drain region (230) in the first direction (X) is greater than a shortest distance (p1) between the gate metal layer of the gate structure (210) and the source region (220) in the first direction (X).

6. The semiconductor device of any one of claims 1 to 5,
wherein in the first semiconductor element (200), a shortest distance (d2) between respective lower surfaces of the gate structure (210) and the drain region (230) in the third direction (Z), perpendicular to the first direction (X) and the second direction (Y), is less than a shortest distance (d1) between respective lower surfaces of the gate structure (210) and the source region (220) in the third direction (Z).

7. The semiconductor device of any one of claims 1 to 6,
wherein a width (W4) in the first direction (X) of the drain region (430a) included in the first semiconductor element (400a) is greater than a width (W3) in the first direction (X) of the source region (420a).

8. The semiconductor device of any one of claims 1 to 7,
wherein in the first semiconductor element (200a), respective thicknesses (h4, h3), in the third direction (Z), of the drain region (230a) and the source region (220a) are substantially identical to each other.

9. The semiconductor device of any one of claims 1 to 7,
wherein in the first semiconductor element (200), respective thicknesses (h2, h1), in the third direction (Z), of the drain region (230) and the source region (220) are different from each other.

10. The semiconductor device of any one of claims 1 to 9,
wherein in the first semiconductor element (200a), a position of an upper surface of the drain region (230a) and a position of an upper surface of the source region (220a) are different from each other in the third direction (Z), relative to the surface of the substrate (203).

11. The semiconductor device of any one of claims 1 to 10,
wherein in the first semiconductor element (200a), an upper surface of the drain region (230a) is above an upper surface of the source region (220a) in the third direction (Z).

12. The semiconductor device of any one of claims 1 to 9,
wherein in the first semiconductor element (200), respective positions of an upper surface of the drain region (230) and an upper surface of the source region (220) are substantially identical to each other in the third direction (Z), relative to the surface of the substrate (203).

13. The semiconductor device of any one of claims 1 to 12,
wherein the drain region included in the first semiconductor element (200b) includes a first drain region (230b), and a second drain region (235b) between the first drain region (230b) and the gate structure (210b), and
wherein the second drain region (235b) is configured having a doping concentration lower than a doping concentration the first drain region (230b).

14. The semiconductor device of any one of claims 1 to 13,
wherein the first semiconductor element (300a) includes a counter doping region (331a) doped with second conductivity type impurities different from the first conductivity type impurities between the gate structure (310a) and the drain region (330a).

15. The semiconductor device of claim 14,
wherein the counter doping region (331a) is in direct contact with the gate structure (310a) and the drain region (330a).
